# EUROPEAN PATENT APPLICATION

(11) **EP 1 083 463 A2**
(43) Date of publication of application: **14.03.2001**
(21) Application number: 00307407.7
(22) Date of filing: 29.08.2000
(51) Int. Cl.: G03F 7/20

(54) **Patterning method and semiconductor device**

(30) Priority: 10.09.1999 US 153338 P; 27.06.2000 US 604937
(71) Applicant: LUCENT TECHNOLOGIES INC., Murray Hill, New Jersey 07974-0636 (US)
(72) Inventor: Blatchford, James W., JR., Orlando, Florida 32837 (US); Nalamasu, Omkaram, Bridgewater, New Jersey 08807 (US); Pau, Stanley, Hoboken, New Jersey 07030 (US); Trimble, Lee Edward, Orlando, Florida 32836 (US)
(74) Representative: Buckley, Christopher Simon Thirsk

(57) **Abstract**

A method useful in a radiation-sensitive-material exposure system having a radiation source, a phase-shifting mask and a focal plane. Radiation is transmitted from the source through the phase-shifting mask onto a radiation-sensitive-material. The spatial relationship between the focal plane and the radiation-sensitive-material is adjusted and radiation is transmitted from the source through the phase-shifting mask onto a radiation-sensitive-material after again. The technique may be repeated at any number of focal plane positions to improve simultaneously the imaging process resolution and depth of focus.

## Description

This application claims the benefit under Title 35 U.S.C. §120 of United States Provisional Application No. 60/153,338, filed on September 10, 1999.

### TECHNICAL FIELD OF THE INVENTION

This invention relates to lithography, such as that used for fabricating semiconductor devices. More particularly, the invention relates to patterning layers using a phase-shifting mask in conjunction with focus drilling.

### BACKGROUND OF THE INVENTION

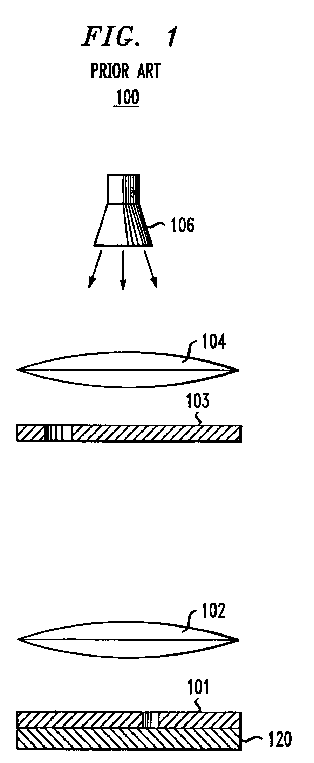

Lithography is utilized in semiconductor device manufacturing to pattern features on device layers. FIG. 1 shows a lithographic fabrication system 100 for defining features on a workpiece 120, in accordance with prior art. Typically, workpiece 120 comprises a semiconductor substrate, together with one or more layers of substances (not shown) such as silicon dioxide and a radiation sensitive layer such as a photoresist 101, affixed to a surface of workpiece 120.

Radiation of wavelength λ is emitted by an optical source 106, such as a mercury lamp or a laser. The radiation propagates through an optical collimating lens or lens system 104, a lithographic mask 103 having a pattern of opaque and transparent features, and an optical projection lens or lens system 102. The radiation transmitted through mask. 103 is imaged by lens 102 onto photoresist layer 101, thereby exposing a patterned area corresponding to the mask pattern. If photoresist layer 101 is positive, exposed areas will be subject to removal after development and if it is negative, exposed areas will remain intact while non-exposed areas will remain intact. Thus, the pattern of mask 103 is transferred to photoresist layer 101. "Mask" as used herein means "mask" and/or "reticle".

When the feature size is comparable to l/NA, where l is the illumination wavelength, and NA is the numerical aperture of the projection system, diffraction effects are likely to be produced, decreasing the image resolution. For semiconductor devices it is desirable to maximize the number of circuit components per unit area by minimizing component size. However, undesirable diffraction effects become more significant with small dimension pattern features. "Small dimension" as used herein means small size and small spacing between transparent regions relative to λ/NA. Decreased sharpness of mask images caused by diffraction effects may reduce product yield and increase device failure rate.

It is known in the art to improve the system resolution by employing a phase-shifting mask. The mask imparts a phase-shift to the incident radiation, typically by π radians, although other degree amounts have been used. Phase-shifting masks generally comprise transparent areas having an optical intensity transmission coefficient T, substantially equal to 1.0 at the incident radiation wavelength λ, attenuating areas or partially transparent areas having T at λ in the range of about 0.05 to about 0.15, and, optionally, opaque areas, having T less than or equal to about 0.01.

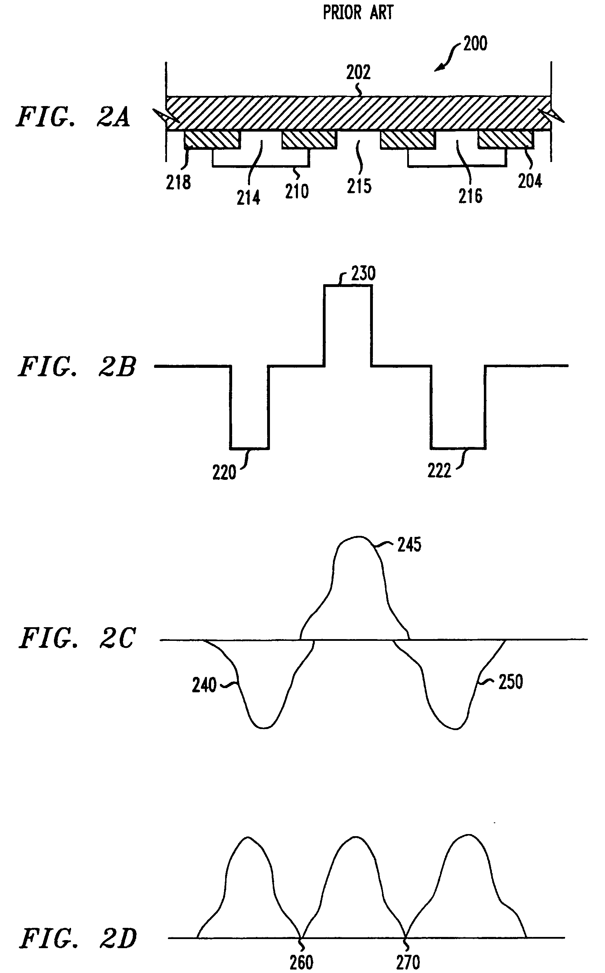

The phase shift is accomplished by incorporation of a phase shifting layer into the mask. This may be done in a variety of ways. For example, FIG. 2A depicts a cross-sectional view of a prior art alternating π radian-phase-shifting mask 200. Mask 200 comprises a glass or quartz layer 202 with a patterned chromium layer 204 affixed thereto. The patterned chromium layer comprises plurality of substantially transparent openings 214, 215 and 216 and a plurality of attenuating areas 218. A phase-shifter layer 210 is present over transparent openings 214 and 216.

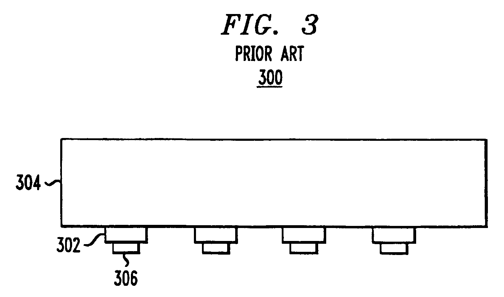

Other types of phase-shifting masks include, but are not limited to, rim shifter masks and attenuated phase-shifting masks. A rim shifter mask 300 is depicted in FIG. 3. Patterned layer 302 is disposed on substrate 304. Phase-shifter layer 306 is disposed on patterned layer 302 at least partially covering patterned regions of layer 302.

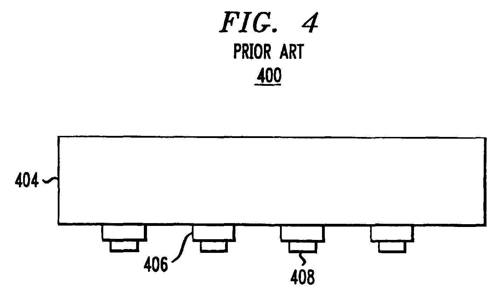

Attenuated phase-shift mask 400 depicted in FIG. 4, comprises phase-shifting layer 406 disposed on substrate layer 404. Phase-shifting layer 406 serves as both the phase shifting and absorbing material. Phase-shifting layer 406 may comprise one or more dielectric layers. An opaque material 408 may be disposed on phase-shifting layer 406 to provide an optical proximity correction. The proximity effect is a phenomenon wherein exposure doses in one vicinity of a workpiece affect the exposure doses in neighboring vicinities primarily from light scattering and reflection. The effect is most significant at corner regions of a pattern where radiation contributions from surrounding areas are more likely to become integrated. The proximity effect becomes more pronounced as spaces between pattern elements become smaller.

For simplicity the basic principles of phase-shifting masks shall be described in terms of the alternating phase-shifting mask. Phase-shifting layer 210 reverses the direction of electric field vectors at apertures 214 and 216 relative to aperture 215 as shown in FIG. 2B at 220, 222 and 230. Phase-shifting layer 210 modifies the optical distance traveled by incident radiation, thereby producing a π radian phase-shift. As is shown in FIG. 2C, by peaks 240, 245 and 250, the overlapping regions of adjacent electric fields have opposite amplitudes, and therefore, a destructive interference occurs. The cancellation of the electric field at those locations improves the contrast of the intensity field as shown in FIG. 2D at 260 and 270.

Phase-shifting masks producing π radian shifts may not resolve all patterning problems. Phase conflict problems may still arise for feature configurations in which a phase transition is generally unavoidable. Whenever a phase transmission occurs an undesirable dark line will result.

U.S. Patent No. 5,916,711 addresses phase conflict. Auxiliary transmissive phase regions with properly selected locations and dimensions are introduced to eliminate unwanted interference problems. A usual opaque region between the transmissive features that are phase-conflicting to one another is partially or entirely replaced with a transmissive region of an opposite phase with respect to the phase of the transmissive features.

Depth of focus problems are another patterning obstacle not resolved by conventional phase-shifting masks or by solutions such as provided in U.S. Patent No. 5,916,711. Depth of focus problems arise when the thickness of the radiation-sensitive layer being exposed is greater than the depth of focus. The radiation-sensitive material may be applied thicker than the depth of focus because of the material composition, processing requirements or because of topographical variations on the workpiece surface. Such topographical variations are common on semiconductor device layers during manufacturing, for example when a photoresist layer is disposed on a layer wherein device components or portions thereof already exist. The topography of the components is reflected in that of the photoresist layer. In conventional lithographic methods the surface is exposed with the focal plane at one location with respect to the radiation-sensitive material, If the depth of focus is less than the radiation-sensitive material depth, some portions being exposed may be out of focus, thereby reducing resolution. It is often desirable to have a relatively small depth of focus to improve resolution in a particular plane. The focal depth of a projection lens is inversely proportional to the square of the numerical aperture. Therefore, when the numerical aperture is increased, which is often done to improve resolution, the depth of focus decreases. Thus, improved resolution in one plane may be at the expense of resolution in another plane.

A technique generally referred to as "focus drilling" has been utilized to address depth of focus problems. The technique is used when the thickness of the radiation-sensitive material is greater than the depth of focus of the exposure system. The system is adjusted with the focal plane located at a first position relative to a reference level to expose a layer of the radiation-sensitive material substantially parallel to the focal plane. The system is readjusted to locate the focal plane at a second position along the system's optical axis within the radiation-sensitive material. A second exposure is made at the second position. The procedure may be repeated until the fill depth of the radiation-sensitive material is exposed.

U.S. Patent No. 4,904,569 discloses a focus drilling method that is utilized to compensate for topographical variations. A photoresist film is formed on a surface having a topography. The photoresist film is exposed a plurality of times so that the image or focal plane of the mask pattern is formed at a plurality of positions. The focal planes are spaced apart from a reference plane in the substrate in the direction of an optical axis. This enhances the effective focal depth of the projection aligner.

Focus drilling addresses resolution of features on a surface having a varied topography and within radiation-sensitive materials having thicknesses greater than the depth of focus of the exposure system. However, focus drilling does not reduce diffraction effects commonly associated with subwavelength dimensioned features. Therefore, a need exists for a method to improve resolution of submicron features particularly when a radiation-sensitive material is applied with a thickness greater than the depth of focus.

### SUMMARY OF THE INVENTION

Embodiments of the invention are particularly applicable to semiconductor device manufacturing photolithography processes, providing improved accuracy of contact window and trench formation.

Embodiments of the invention are useful in a radiation-sensitive-material exposure system having a radiation source, a phase-shifting mask and a focal plane. Radiation is transmitted from the source through the phase-shifting mask onto a radiation-sensitive-material. The spatial relationship between the focal plane and the radiation-sensitive-material is adjusted and radiation is again transmitted from the source through the phase-shifting mask onto a radiation-sensitive-material. The process may be repeated at any number of focal plane positions.

### DESCRIPTION OF THE DRAWINGS

FIGURE 1 depicts a prior art lithographic fabrication system
FIGURES 2 A-D depict a prior phase-shifting mask and associated electric fields
FIGURE 3 depicts a prior art rim-shifter mask
FIGURE 4 depicts a prior art attenuated phase-shifting mask
FIGURES 5 a-d depict Bossung plots for chilled and undrilled contact windows

### DETAILED DESCRIPTION OF THE INVENTION

Embodiments of the invention enable semiconductor devices with submicron features to be fabricated with improved yield, performance and reliability compared to devices manufactured using conventional methods.

A workpiece, for example a partially fabricated semiconductor device, is situated in a radiation-sensitive material exposure system. A typical system comprises a radiation source, a phase-shifting mask, a component such as a platform for accommodating the workpiece and an associated focal plane. The workpiece has a layer of radiation-sensitive material disposed thereon. The system is adjusted so that the focal plane is at least partially within the radiation-sensitive material. Radiation from the source is transmitted through the phase-shifting mask onto the radiation-sensitive-material, thereby patterning the radiation-sensitive material according to features present on the phase-shifting mask. The radiation-sensitive material is exposed substantially within the depth of focus of the system. The depth of focus however may be less than the thickness of the radiation-sensitive-material layer. Reducing the thickness of the layer to assure exposure throughout the layer depth is not always an option. Radiation-sensitive material properties, deposition methods or other process requirements or variables may limit how thin the applied layer may be. Additionally, the surface upon which the radiation-sensitive material is disposed may have topographic variations greater than the depth of focus that may be reproduced in the radiation-sensitive material.

To expose the radiation-sensitive material throughout its thickness the system is adjusted to change the spatial relationship between the focal plane and the radiation-sensitive-material after a first exposure is made. After adjusting the system, radiation is transmitted again from the source through the phase-shifting mask onto the radiation-sensitive material. This allows an additional portion of the radiation-sensitive material thickness to be exposed. Exposures may be repeated at any number of focal plane positions. In one embodiment of the invention, the total depth of focus using a plurality of exposures is greater than about 0.4µm, more preferably greater than about 0.6µm and most preferably greater than about 0.7µm.

Adjustments to the spatial relationship between the focal plane and the radiation-sensitive material may be achieved in any manner compatible with the system being used and which allows for the desired exposure area or volume. The simplest adjustments will be made by moving the workpiece with respect to the radiation source or moving the radiation source with respect to the workpiece while maintaining other system components in their original positions and not varying the exposure system environment. Generally the workpiece will be moved by moving a system component on which the workpiece is located. Additionally or alternatively, a property affecting the system's depth of focus may be adjusted to relocate the focal plane at least partially within the radiation-sensitive material. For example, it may be possible to change the aperture size to relocate or expand the focal plane, move the mask, apply a material to the workpiece or mask to change the refractive index, change the type or number of the radiation sources, modify the pressure and/or temperature of the system, change the type, number or location of lenses, or make any other modifications compatible with the system and workpiece that causes a spatial relation change of the focal plane with respect to the radiation-sensitive material layer.

The focal plane is preferably substantially parallel to the radiation-sensitive material surface plane, the surface plane being defined by the top surfaces of areas having substantially the same height. The spatial relationship between the focal plane and the radiation-sensitive material surface plane is preferably adjusted by increasing or decreasing the distance between the two planes substantially along the system's optical axis while keeping the planes parallel. The planes may be offset and then moved perpendicularly toward or away from one another. However, the two planes need not be parallel and adjustments need not be made along the system's optical axis. Therefore, distances between the planes as described herein include perpendicular and angular distances.

The number of focal planes used and their spatial relationship may differ from that which are used in a conventional binary mask/focal drilling method, in part due to the greater depth of focus obtained with the phase-shifting mask process. Numerous factors must be weighed including, but not limited to, stepper parameters such as exposure wavelength, illumination coherence and numerical aperture, radiation-sensitive material characteristics, feature size, mask properties and exposure dose. Following is a description of some factors which may be considered to determine the optimum number and spatial relationship between focal planes.

When exposing a thickness of radiation-sensitive material the distance between consecutive focal planes may be substantially equal or may vary. The distance may create an overlap of focal depths or may allow adjacent focal depths to generally abut one another. A minimal overlap that assures complete exposure of desired areas is preferable. Such positioning will be dependent at least in part on the system design and workpiece configuration.

Exposures may be taken wherein focal planes are at finite increments within the radiation-sensitive material layer or wherein the focal planes are continuous with respect to one another. Discrete steps may be controlled with higher precision than use of a continuously vibrating stage. Thus, discrete focus drilling may yield better pattern transfer quality than continuous focus drilling.

The distance between the focal plane nearest the radiation source and the focal plane farthest from the radiation source is generally dependent on the thickness of radiation-sensitive material being exposed. Nearly any span of focal planes is possible, limited primarily by the design of the exposure system. In one embodiment the distance between the focal plane nearest the radiation source and the focal plane farthest from the radiation source is in the range of about 0.5 to about 2.0 times the depth of focus. In another embodiment of the invention five focal plane positions are used wherein the distance between consecutive focal planes is substantially equal to the depth of focus of the system being used. The system's depth of focus can be determined experimentally for a particular process or can be calculated by numerical simulation.

At any particular focal plane position, radiation may be transmitted through one or more masks to achieve desired patterning. The masks may all be phase-shifting masks or may include at least one phase-shifting mask and at least one non-phase-shifting mask. Multiple masks may be used at a particular level for example to delineate a gate level. The phase-shifting mask defines a gate region and the binary mask is used to expose an area where there is phase conflict in the phase shifting-mask.

Advantageously nearly any radiation-sensitive material thickness may be sufficiently exposed by exposing the material at an adequate number of focal plane positions within the material. The minimum number of focal plane positions necessary is roughly equal to the material thickness divided by the depth of focus. In one embodiment of the invention the thickness of the radiation-sensitive material is in the range of about 250 nm to about 500 nm, more preferably in the range of about 300 nm to about 400 nm. However, the radiation-sensitive material may have any thickness sufficient to cover any topographical variations desired to be covered, with an upper limit primarily dependent on the photoresist properties and deposition method. Generally, the thickness used is near the minimum which provides a sufficient bather to etching processes and covers all desired areas.

The radiation-sensitive material should be exposed with a dose of radiation sufficient to transform the material's properties as desired, for example, to render the material soluble in a particular solvent. The exposure dose depends in part on the phase-shifting mask used, the radiation-sensitive material properties, the system properties and the desired exposure pattern. In one embodiment Shipley UV6 photoresist is used with five discrete 248nm exposures. The exposure dose per focal plane for these parameters is preferably in the range of about 5 mJ/cm² to about 10 mJ/cm². When employing a Sumitomo PAR photoresist and five discrete 193nm exposures, the dose is preferably in the range of about 2 mJ/cm² to about 4 mJ/cm². Thus, generally the preferred exposure dose is in the range of about 2 mJ/cm² to about 10 mJ/cm². The exposure dose may be the same at each focal plane or may vary between two or more focal planes. The doses should sufficiently expose radiation-sensitive material desired to be exposed and shield other areas so they remain unexposed. In one embodiment of the invention the first exposure is made when the focal plane is positioned to expose a portion of the radiation-sensitive material nearest to the radiation source. One or more subsequent exposures are made with the focal plane positioned to expose material increasingly farther into the layer. The exposure dose is increased for each consecutive exposure so that the cumulative exposure dose for all levels within the radiation-sensitive material after all exposures are performed, is substantially the same. Similarly, the focal plane may be positioned to expose a portion of the radiation-sensitive material at positions increasingly nearer to the radiation-sensitive material surface while decreasing the exposure dose for consecutive positions. Doses need not only ramp up or down upon consecutive exposures, but may have any sequence of increases and decreases. This may produce radiation-sensitive material walls around exposed areas that are not planar which may be desirable in some applications.

Embodiments of the invention may generally be useful for any radiation exposure system but they are particularly applicable to systems in which depth of focus problems exist such as in optical or x-ray exposure systems. Embodiments of the invention are especially useful for photolithography applications. Photolithography exposure systems generally have ultra violet radiation sources which may include, but are not limited to, KrF 248 nm lasers, ArF 193 nm lasers, Hg arc lamps and F₂ 157 nm lasers. Preferably the coherence factor of the radiation is in the range of about 0.3 to about 0.7, and more preferably in the range of about 0.3 to about 0.5. This range provides sufficient accuracy of the phase shift. Fully coherent radiation is more preferable but not necessary to achieve desired resolution. The numerical aperture of the system or stepper will also affect the resulting resolution and should be considered. Numerical apertures typically range from about 0.53 to about 0.68.

Both conventional and off-axis illumination systems may be used. Off-axis illumination may enhance the depth of focus and resolution by having only zero-order and first-order diffracted radiation interfering on the workpiece surface and contributing to image formation.

The radiation-sensitive material used should be compatible with the exposure process and the solvent used therewith. It preferably has relatively high contrast and high etch selectivity. Radiation-sensitive materials with good surface inhibition generally have relatively high contrast, i.e. gamma greater than about 5. The dissolution rate of the exposed surface area of the radiation-sensitive material should be about half or more of the bulk exposed material, illustrative dissolution rates ranges for exposed areas are about 1000 A/sec to 30,000 A/sec and 2500 A/sec to 6500 A/sec. The dissolution rate of unexposed areas is preferably less than 5A and more preferably less than 1A. It is also desirable that radiation-sensitive material does not significantly out gas and that it has good adhesion to the layer on which it is disposed. A bilayer resist system may also be utilized wherein a thin imaging layer, typically having a thickness in the range of about 50 nm to about 500 nm is used over a thicker planarizing layer or anti-reflection coating. The images defined in the imaging layer are transferred into the underlying layer by plasma etching.

The type of radiation-sensitive material used depends in part on the radiation source type. For example, for a photolithographic system photoresists are generally used. Photoresists are polymers that after exposure to ultraviolet radiation either dissolve in a particular solvent or become less soluble depending on the type of photoresist. A positive photoresist becomes more soluble when exposed to ultra violet radiation and a negative photoresist becomes less soluble. Photoresists are particularly applicable to lithographic processes used in semiconductor device formation. Particularly negative photoresists have been found to provide a significant increase in focus latitude.

The phase-shifting mask through which radiation is transmitted to expose the radiation-sensitive material may be of any type that is compatible with the exposure system, and patterns the workpiece in the desired manner. Examples of phase-shifting masks include, but are not limited to, embedded attenuated and strong phase-shifting masks. Embedded attenuated masks typically have attenuated regions having transmissions in the range of about 6 % to about 20 %. A strong phase-shifting mask has opaque and transparent regions. In one embodiment of the invention the mask comprises substantially attenuated regions having a transmission of less than about 10 %. In one embodiment of the invention the mask is a rim shifter mask.

The mask may shift radiation by any amount or amounts that will improve resolution as compared to a binary or non-phase-shifting mask. In one embodiment of the invention the mask phase shifts radiation by 0 and π radians. In another embodiment of the invention the mask phase shifts radiation by 0, 2/3π and 4/3π radians. Masks may also incorporate any other resolution improving technologies. In one embodiment of the invention the mask corrects at least partially for the proximity effect. The correction provides more uniform exposure doses in neighboring vicinities.

Advantageously, features having any width including widths less than the radiation wavelength may be accurately transferred. In one embodiment of the invention the feature width is in the range of about 0.5 to about 1.5 times the radiation wavelength. For example, with a radiation wavelength of about 248 nm, features having a width of .124 nm or greater may be accurately transferred. The feature width is more preferably in the range of about 0.6 to about 1.0 times the radiation wavelength, and most preferably in the range of about 0.7 to about 0.9 times the radiation wavelength.

In terms of specific widths, one embodiment of the invention includes a feature width less than .25µm. In another embodiment the feature width is preferably in the range of about .14µm to about .30µm and more preferably in the range of about .15µm to about .25µm.

Another significant advantage of embodiments of the invention is the achievable pitch. Pitch as used herein refers to the spacing between features as measured center-to-center, perpendicularly from a feature center line. In one embodiment of the invention the pitch is less than about 500nm. More preferably the pitch is less than about 400nm, and most preferably the pitch is less than about 300nm.

The achievable ratio of spacing between patterned elements and the dimension of the patterned elements, which is referred to as the duty cycle, is an important consideration for many technologies. In many applications, such as for semiconductor devices, it is advantageous to minimize spacing between elements to increase the density of features. Patterns with duty cycles of greater than about 0.8:1.0 have been successfully transferred using embodiments of the invention. It is believed that patterns having duty cycles in the range of about 0.7:1.0 to about 0.9:1.0 may be successfully utilized with embodiments of the invention.

Aspects of the invention are particularly applicable to semiconductor device contact window and trench formation. Trenches are deep narrow grooves, typically filled with oxide or polysilicon, formed between active device components such as transistors, to electrically isolate them from one another. Contact windows are openings made through a dielectric layer and filled with metal to form an electrical connection between circuit components located in layers adjacent to the dielectric layer. The process latitude and resolution limit of printing contact windows has been investigated. Experiments show that the use of a phase-shifting mask in conjunction with a focus drilling procedure extends the depth of focus of subwavelength window printing.

### Experimental Results

An attenuated phase-shifting mask was utilized having 240 nm films of CrFₓ and Cr on quartz substrate and manufactured by Dai Nippon Printing Co. The mean phase and transmission, measured at 248 nm, were 180.6° and 5.89% with standard deviations of 2.6° and 0.16%, respectively. A Nikon S201 stepper having a numerical aperture of 0.6 and sigma of 0.4 was used to expose commercially available positive UV82 photoresist with a 60 nm AR3 antireflection coating. The stepper performed processes on eight inch wafers according to MCSV version 1.61 B software. The radiation source was a KrF laser having a 248 nm wavelength. Each exposure field was split into a plurality of substantially equally sized subfields as measured along the x-axis. The number of subfields was equal to the number of focal planes at which exposures were to be made. The number of subfields used was typically five. The same portion of the mask was used to expose each subfield. The subfields were offset so that exposed areas would be superimposed on the wafer. Contact windows having dimensions half the exposure wavelength were adequately printed using both positive and negative resists based on commercially acceptable standards.

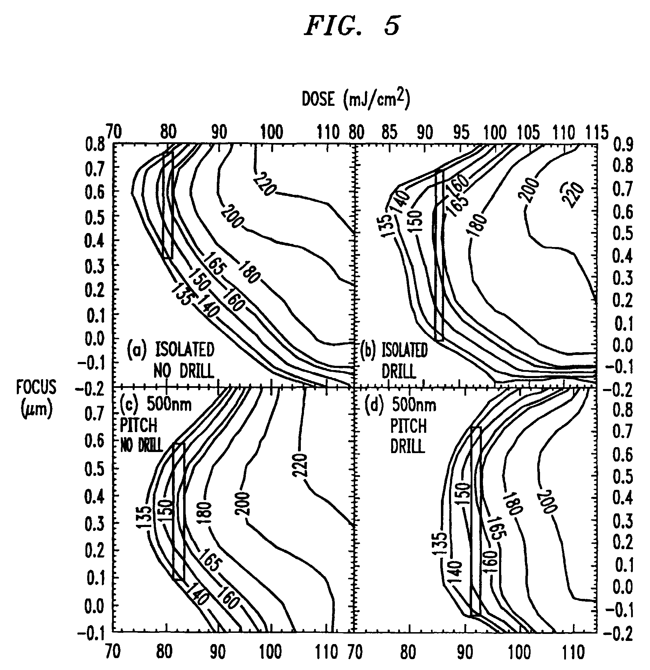

Focus drilling experiments were performed for contact windows having pitches of 1200 nm and 500 nm using positive photoresist. The pitch was taken as the perpendicular center-to-center distance between adjacent contact windows. Contact windows having a 1200 nm pitch were classified as "isolated". The focus drilling was done using five exposures, each with a focus offset of 300 nm. FIGS 5 a-d show Bossung plots for contact windows with and without focus drilling. The measurements in the figures were taken from top-down SEM images. The contour lines represent critical dimension values achieved for particular doses and focus settings. The acceptable critical dimension was selected at 150 nm ± 10 % so that the acceptable values were 135 nm to 165 nm. The mask pattern consisted of a square dimension *d* with unity transmission wherein *d* = 200 nm. A dose latitude of 2 mJ/cm² and a critical dimension of 150 nm were used. An increase in focus latitude was observed from 420 nm without focus drilling to 760 nm with focus drilling for 1200 nm pitch contact windows, and 500 nm to 840 nm for 500 nm pitch contact windows. This represents an 80% focus latitude increase for isolated features and a 40% focus latitude increase for features with a 500 nm pitch.

Following is an example of one embodiment of the invention in which a 150 nm contact window is printed. Stepper parameters include an exposure wavelength of 248 nm, a coherence of 0.3, and a numerical aperture of 0.6. A Shipley UV6 photoresist is used with a 6% transmission attenuated phase shift mask. The feature is represented as a 200 nm contact window on the mask and prints as 150 nm on the wafer. The focus latitude for a single exposure is measured to be 420 nm. The focus drilling consists of five exposures with a step size of 300 nm.

A further embodiment of the invention includes a semiconductor device having a plurality of features, wherein at least one feature is patterned according to embodiments of the invention described herein. At least one feature is patterned using one or more phase-shifting masks and focus drilling. Generally a radiation-sensitive-material exposure system having a radiation source, a phase-shifting mask and a focal plane is utilized to fabricate at least a portion of the semiconductor device. Radiation is transmitted from the source through the phase-shifting mask onto a radiation-sensitive material on the partially formed device. The system is adjusted to change the spatial relationship between the focal plane and the radiation-sensitive-material. Radiation is again transmitted from the source through the phase-shifting mask onto a radiation-sensitive-material after adjusting the system. Additional adjustments may be made and exposures made at the adjusted positions.

While the invention has been described in what is presently considered to be preferred embodiments, many variations and modifications will become apparent to those skilled in the art. Accordingly, it is intended that the invention not be limited to the specific illustrative embodiments but be interpreted within the full spirit and scope of the appended claims.

## Claims

1. A method useful in a radiation-sensitive-material exposure system having a radiation source, a phase-shifting mask and a focal plane wherein the method comprises:
a. transmitting radiation from the source through the phase-shifting mask onto a radiation-sensitive-material;
b. adjusting the system at least once to change the spatial relationship between the focal plane and the radiation-sensitive-material; and
c. transmitting radiation from the source through the phase-shifting mask onto the radiation-sensitive-material after each system adjustment.

2. The method of claim 1 wherein the perpendicular distance between consecutive focal planes is substantially equal.

3. The method of claim 1 wherein the radiation sensitive material is a positive photoresist.

4. The method of claim 1 wherein the radiation sensitive material is a negative photoresist.

5. The method of claim 1 wherein the different focal planes are at finite increments.

6. The method of claim 1 wherein the different focal planes are continuous with respect to one another.

7. The method of claim 1 wherein the radiation sensitive material is exposed with the same exposure dose at each focal plane.

8. The method of claim 1 wherein the radiation sensitive material is exposed with an exposure dose that varies between two or more focal planes.

9. The method of claim 1 wherein the exposure dose per focal plane is in the range of about 2 mJ/cm² to about 10 mJ/cm².

10. The method of claim 1 wherein the thickness of the radiation sensitive material is in the range of about 0.2µ to about 0.5 µ.

11. The method of claim 1 wherein the mask defines at least one feature having a width in the range of about 0.5 to about 1.5 times the radiation wavelength.

12. The method of claim 1 wherein an anti-reflective material is layered with the radiation-sensitive material.

13. The method of claim 1 wherein the radiation is ultra violet.

14. The method of claim 1 wherein the mask has a duty cycle in the range of about 0.7:1.0 to about 0.9:1.0.

15. The method of claim 1 wherein the radiation is x-ray.

16. The method of claim 1 wherein the phase-shifting mask is selected from the group consisting of attenuated and strong.

17. The method of claim 1 wherein the mask includes optical proximity corrections.

18. The method of claim 1 further comprising transmitting radiation through more than one mask at at least one focal plane, wherein at least one mask at each level is a phase-shifting mask and additional masks are selected from the group consisting of phase-shifting and non-phase-shifting.

19. The method of claim 1 wherein the dissolution rate of an exposed surface area of the radiation-sensitive material is at least about half of the bulk exposed radiation-sensitive material.

20. The method of claim 1 having five focal planes wherein the distance between consecutive focal planes is substantially equal to the depth of focus of the exposure system.

21. The method of claim 1 further comprising off-axis illumination.

22. The method of claim 1 wherein the transmission of radiation at a plurality of focal plane positions produces a depth of focus greater than 400 nm.

23. The method of claim 1 wherein the transmission of radiation at a plurality of focal plane positions produces a depth of focus greater than 600 nm.

24. The method of claim 1 wherein the transmission of radiation at a plurality of focal plane positions produces a depth of focus greater than 700 nm.

25. The method of claim 1 wherein radiation-sensitive material has a gamma value of greater than about 5.

26. The method of claim 1 wherein the radiation-sensitive material has an exposed area dissolution rate in the range of about 1000 A/sec to 30,000 A/sec.

27. The method of claim 1 wherein the radiation-sensitive material has an exposed area dissolution rate in the range of about 2500 A/sec to 6500 A/sec.

28. The method of claim 1 wherein the radiation-sensitive material has an unexposed area dissolution rate in the range of less than about 5 A/sec.

29. The method of claim 1 wherein the radiation-sensitive material has an unexposed area dissolution rate in the range of less than about 1 A/sec.

30. A semiconductor device having a plurality of features wherein at least one feature is patterned using a radiation-sensitive-material exposure system having a radiation source, a phase-shifting mask and a focal plane and wherein the feature(s) is patterned by:
a. transmitting radiation from the source through the phase-shifting mask onto a radiation-sensitive-material;
b. adjusting the system at least once to change the spatial relationship between the focal plane and the radiation-sensitive-material; and
c. transmitting radiation from the source through the phase-shifting mask onto the radiation-sensitive-material after each system adjustment.

31. The semiconductor device of claim 30 wherein the width of the feature is in the range of about .14µm to about .30µm.

32. The semiconductor device of claim 30 wherein the width of the feature is in the range of about .15µm to about .25µm.

33. The semiconductor device of claim 30 comprising a plurality of features patterned by steps a-c and having a pitch less than about 500nm.

34. The semiconductor device of claim 30 comprising a plurality of features patterned by steps a-c and having a pitch less than about 400nm.

35. The semiconductor device of claim 30 comprising a plurality of features patterned by steps a-c and having a pitch less than about 300nm.

36. The semiconductor device of claim 30 wherein the feature is a trench.

37. The semiconductor device of claim 30wherein the feature is a contact window.
